# DEMANDE DE BREVET EUROPEEN

(11) **EP 0 849 799 A1**
(43) Date de publication de la demande: **24.06.1998**
(21) Numéro de dépôt: 97402895.3
(22) Date de dépôt: 02.12.1997
(51) Int. Cl.: H01L 25/04, H01L 27/146

(54) **Détecteur à photoconducteur bispectral**

(30) Priorité: 04.12.1996 FR 9614852
(71) Demandeur: THOMSON-CSF, 75008 Paris (FR)
(72) Inventeur: Krapf, Pascal, 94117 Arcueil Cedex (FR); Costard, Eric, 94117 Arcueil Cedex (FR); Bois, Philippe, 94117 Arcueil Cedex (FR)

(57) **Abrégé**

Ce détecteur comporte :
- au moins deux éléments détecteurs actifs (D1, D2) empilés de forme plane séparés par une couche de contact commune de lecture (Cc), l'ensemble étant enserré entre deux couches de contacts de commande (C1 et C2) et les deux éléments détecteurs étant sensibles à des longueurs d'ondes différentes ;
- des moyens pour appliquer successivement une tension de commande à chaque couche de contact (C1, C2, Cc);
- des moyens connectés à la couche de contact commune (Cc) pour détecter un courant de photoconduction à chaque application d'une tension de commande.

Application : Détection de deux gammes de longueurs d'ondes différentes.

## Description

L'invention concerne un détecteur d'onde électromagnétiques et notamment un détecteur à photoconducteur bispectral.

L'invention trouve une application préférentielle dans la réalisation d'une matrice de détection bispectrale.

Des systèmes de détection sensibles dans deux bandes spectrales sont utilisables pour des applications telles que l'identification ou la reconnaissance d'objets. En effet, la mesure de l'émission thermique d'un objet dans deux bandes spectrales différentes permet d'en déduire sa température ou sa distance par rapport à l'observateur, ce qui apporte des suppléments d'information par rapport à une image monospectrale. On trouvera un exemple d'un détecteur à puits quantiques pouvant détecter deux longueurs d'ondes dans la demande de brevet français n° 92 08384.

Les détecteurs bi-bande intégrés permettent d'obtenir l'information des deux bandes sur chaque pixel d'un même plan focal, réduisant ainsi le poids, la puissance électrique et le coût du système complet. De plus l'intégration dans un même plan focal de tels détecteurs ne nécessite aucun alignement optique.

Selon l'invention, un détecteur bi-bande intégré se compose d'un empilement déposé sur un substrat, de deux couches actives et de trois couches pour les contacts électriques (figure 1). Le signal de la couche active D1 est collecté entre les contacts C1 et Cc et le signal de la couche active D2 est collecté entre C2 et Cc. Cependant, les technique d'hybridation n'autorisent pas la prise de deux contacts indépendants pour chaque couche active sur des pixels de faible dimension. L'invention propose une configuration de la connexion de tels détecteurs qui permet d'obtenir les deux signaux de façon séquentielle avec une seule prise de contact pour l'adressage des pixels.

L'invention concerne donc un détecteur d'ondes électromagnétiques à photoconducteur comportant :
- au moins un premier et un deuxième éléments détecteurs actifs empilés de forme plane séparés par une couche commune, les deux éléments détecteurs étant sensibles à des longueurs d'ondes différentes ;
- un premier moyen de connexion connecté en commun aux deux éléments détecteurs, un deuxième moyen de connexion connecté au premier élément détecteur, et un troisième moyen de connexion connecté au deuxième élément détecteur ;
- des moyens pour appliquer successivement une tension de commande à chaque moyen de connexion ;
- des moyens connectés au premier moyen de connexion pour détecter un courant de photoconduction à chaque application d'une tension de commande.

Les différents objets et caractéristiques de l'invention apparaîtront plus clairement dans la description qui va suivre et dans les figures annexées qui représentent:
- la figure 1, un empilement de deux détecteurs ;
- les figures 2a à 2d, un ensemble de deux détecteurs avec ces éléments de connexion électrique ;
- les figures 3a et 3b, une matrice de détecteurs bispectraux en vue de dessus et en coupe ;
- les figures 4a à 4c, un exemple de procédé de réalisation du dispositif selon l'invention ;
- les figures 5 à 9, des variantes de réalisation de l'invention.

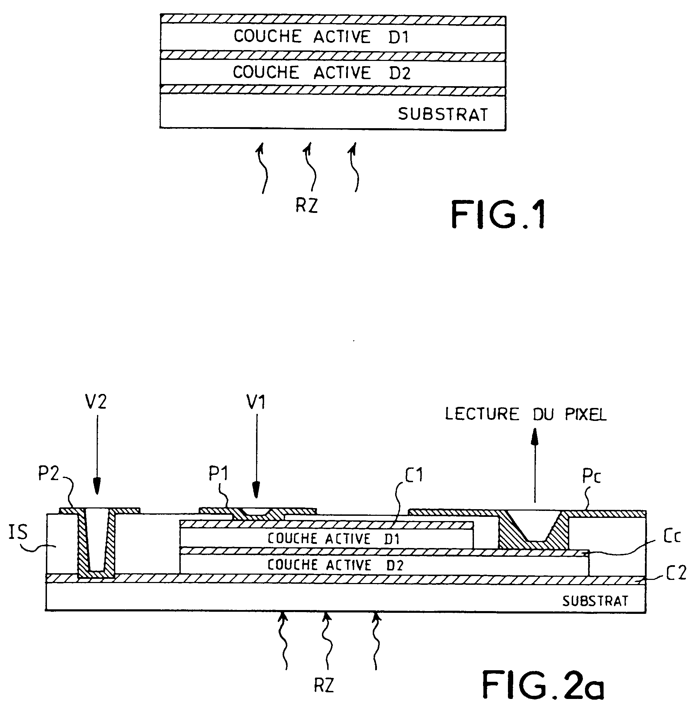

Comme cela est représenté de façon simplifiée sur la figure 1, le détecteur selon l'invention comporte, empilées sur un substrat :
- une couche de contact C2
- une couche active photoconductrice D2
- une couche de contact commune Cc
- une couche active photoconductrice D1
- et une couche de contact C1

Les couches actives photoconductrices D1, D2 peuvent être des couches en matériau photoconducteur. Elles peuvent être également réalisées sous forme d'empilements de couches constituant des détecteurs à puits quantiques. Les deux couches actives D1, D2 sont de caractéristiques différentes de façon à devenir photoconductrices sous l'effet de longueurs d'ondes électromagnétiques (ou de gammes de longueurs d'ondes) différentes. La couche active D1 devient photoconductrice sous l'effet d'une longueur d'onde λ1 et la couche D2 sous l'effet d'une longueur d'onde λ2. Le détecteur recevant un rayonnement RZ, comme indiqué sur la figure 1, la couche active D2 est transparente à la longueur λ1.

Les couches de contact C1 et C2 permettent l'application de potentiels de commande. La couche de contact Cc est commune aux deux éléments détecteurs comprenant les couches actives photoconductrices.

Elle est mise à un potentiel de référence et permet la détection des photocourants générés par les détecteurs D1, D2.

La figure 2a représente une réalisation plus détaillée du détecteur de l'invention selon laquelle le détecteur est encapsulé dans un matériau isolant IS. Les plots de contacts P1, P2, Pc traversent cet isolant et permettent la prise de contacts sur les couches de contact C1, C2, Cc respectivement.

Le substrat est transparent aux longueurs d'ondes à mesurer. Le détecteur reçoit donc un rayonnement RZ à détecter à travers le substrat.

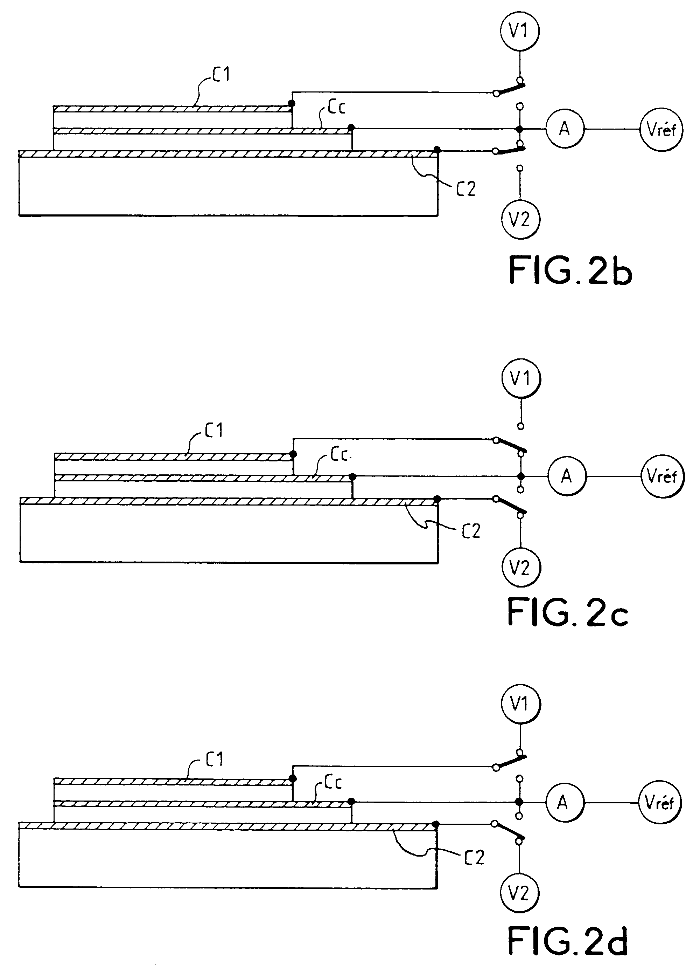

Lorsqu'un rayonnement RZ est reçu par le détecteur, pour détecter deux longueurs d'ondes λ1, λ2 ou gammes de longueurs d'ondes, on applique une tension de référence Vref au plot de contact Pc c'est-à-dire à la couche de contact commune Cc (voir figure 2b). Cette tension de référence peut être par exemple une terre. Ensuite dans un premier temps, on applique un potentiel V1 à la couche de contact C1 (plot P1) et le potentiel de référence Vref à la couche de contact C2 (plot P2). L'élément détecteur D2 est rendu inactif, l'élément détecteur D1 est actif et génère un courant il. Si une longueur d'onde λ1 est contenue dans le rayonnement RZ, le dispositif A détecte ce photocourant i1. Ce fonctionnement correspond à la position des commutateurs K1 et K2 sur la figure 2b.

Dans un deuxième temps, les commutateurs K1, K2 sont commutés dans les positions représentées en figure 2c. Un potentiel V2 est appliqué à la couche de contact C2. Le potentiel de référence Vref est appliqué à la couche de contact C1. L'élément détecteur D1 est alors inactif tandis que l'élément détecteur D2 est rendu actif et génère un photocourant i2 à la réception d'une longueur d'onde λ2. Le dispositif A mesure ce photocourant.

Le dispositif de l'invention a permis ainsi de détecter successivement les longueurs d'ondes λ1 et/ou λ2.

La figure 2d représente le fonctionnement du dispositif lorsque les deux éléments détecteurs D1 et D2 sont actifs. Les commutateurs K1 et K2 leur appliquent respectivement les potentiels V1 et V2. Ces potentiels sont de même signe par rapport au potentiel de référence Vref de telle sorte qu'en présence de longueurs d'ondes λ1 et λ2, les deux éléments détecteurs D1 et D2 génèrent des photocourants de même sens dans le dispositif A. Celui-ci mesure donc la somme des photocourants générés et le signal mesuré correspond à la somme des signaux des deux bandes spectrales.

A titre d'exemple, les potentiels de commande seront de 2 Volts pour V1 et de 4 Volts pour V2.

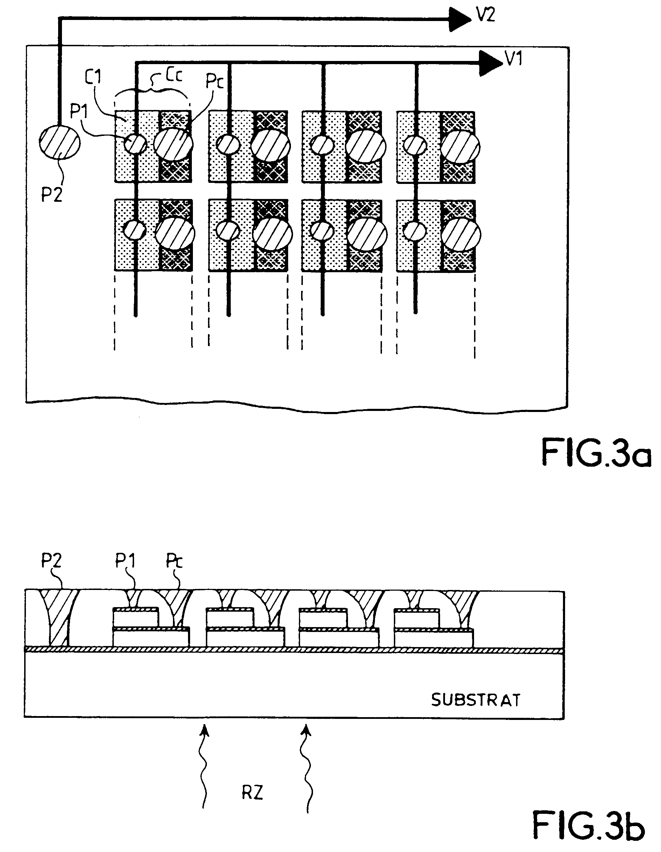

Les figures 3a et 3b représentent en vue de dessus et en coupe une forme de réalisation matricielle d'un détecteur bispectral selon l'invention.

Les différents détecteurs sont réalisés sur une couche de contact de commande C2 commune à tous les détecteurs. Le plot de connexion P2 est donc commun à toute la matrice. Chaque détecteur de la matrice comporte un élément détecteur D1 et un élément détecteur D2 ainsi que les couches de contact C1 et Cc et les plots de connexion P1 et Pc. Les plots de connexion P1 sont tous connectés entre eux pour appliquer un potentiel V1 ou Vref (voir précédemment) à tous les éléments détecteurs D1 de la matrice. La couche de contact C2 et le plot de connexion P2 étant commun à toute la matrice, le potentiel appliqué au plot P2 est appliqués à tous les éléments détecteurs D2 de la matrice.

Pour la lecture des détecteurs de la matrice, chaque détecteur est situé au point de croisement d'un réseau de conducteur de ligne et de colonne. Sur la figure 3c, on n'a représenté uniquement que le plot de connexion Pc de chaque détecteur. A chaque point de croisement est prévu par exemple un transistor Tr dont la base est connectée au fil de ligne. L'émetteur et le collecteur sont connectés respectivement à un plot Pc et un fil de colonne. L'application d'un potentiel approprié sur un fil de ligne permet de commander tous les transistors de la ligne et de connecter tous les plots Pc d'une ligne à des fils de colonnes. Il est ainsi possible de lire sur chaque fil de colonne, le photocourant généré par le détecteur connecté à ce fil de colonne.

Dans cet exemple de réalisation, tous les plots P1 sont interconnectés entre eux et commandé par un même potentiel. Il en est de même pour la couche de contact C2 qui est commune à tous les détecteurs et qui est connectée au plot P2.

Cependant, selon une variante de réalisation, on prévoit que la couche de contact de commande C2 est découpée en bandes de façon que chaque bande soit commune à une ligne de détecteurs. On aura alors un plot P2 par bande de contact C2, c'est-à-dire par ligne de détecteurs.

De façon similaire, au lieu d'interconnecter tous les plots P1, on les interconnecte par lignes de détecteurs. On a un plot P1 par ligne de détecteurs.

Les plots Pc des détecteurs sont interconnectés par des fils de colonnes de la matrice.

Le fonctionnement de la matrice de détecteurs se fait alors séquentiellement par ligne. A chaque temps d'une ligne, on applique le potentiel V1 au plot P1 de cette ligne et le potentiel Vref au plot P2, puis le potentiel V2 au plot P2 et le potentiel Vref au plot P1. La lecture se fait sur les fils de colonnes, chaque fil de colonne permettant la lecture d'un détecteur de la ligne commandée.

Durant chaque commande d'une ligne, le fonctionnement des détecteurs des autres lignes peut être inhibée en appliquant un potentiel Vref aux plots P1 et P2 de ces lignes.

En raison du fonctionnement bispectral des détecteurs (voir description relative aux figures 2b et 2c). Durant chaque temps d'exploration de ligne, on aura un temps de lecture des éléments détecteurs D1 (fonctionnement correspondant à la figure 2b) et un temps de lecture des éléments détecteurs D2 (fonctionnement correspondant à la figure 2c).

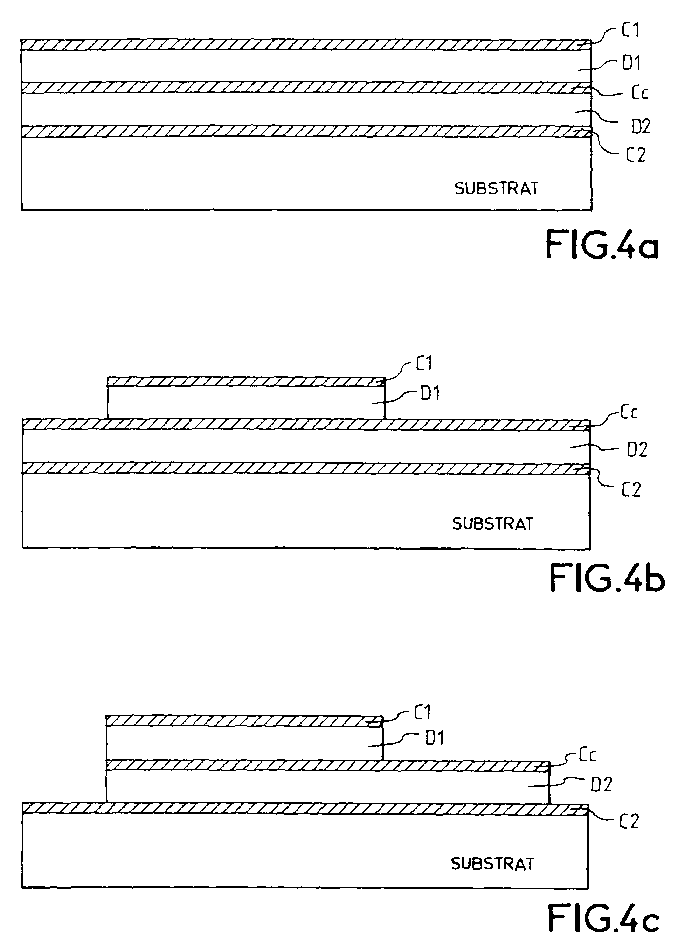

En se reportant aux figures 4a à 4c, on va maintenant décrire un procédé de réalisation d'un détecteur selon l'invention.

Sur un substrat en matériau transparent aux longueurs d'ondes à détecter on réalise successivement une couche de contact C2, une ou plusieurs couches photoconductrices D2 constituant l'élément photodétecteur D2, une couche de contact commune Cc, une ou plusieurs couches photoconductrices D1 constituant l'élément photodétecteur D1, une couche de contact C1 (figure 4a).

L'élément détecteur supérieur D1 est déterminé par gravure ou implantation ionique des couches C1 et D1 avec arrêt de la gravure (ou implantation) sur la couche de contact Cc (figure 4b).

L'élément détecteur inférieur D2 est ensuite déterminé par gravure ou implantation ionique des couches C2 et D2 avec arrêt de la gravure (ou implantation) sur la couche de contact C2 (figure 3c).

L'ensemble est ensuite recouvert d'une couche d'isolant IS (figure 2).

Ensuite trois trous sont réalisés dans la couche d'isolant de façon à accéder aux trois couches de contacts et des dépôts métalliques sont réalisés dans ces trous pour obtenir les plots de contacts P1, P2 et Pc.

Pour la réalisation d'une matrice de détecteurs, les différents détecteurs sont réalisés collectivement comme décrit précédemment. On obtient alors une structure telle que représentée en figure 3b. Comme on l'a vu, le plot P2 est commun à toute la matrice. Il ne reste donc plus qu'à réaliser à la surface de la matrice les conducteurs d'interconnexion des plots P1 puis le réseau matriciel de connexion des plots Pc.

Dans ce qui précède on a décrit l'invention en réalisant des détecteurs à transport vertical comme les détecteurs à multipuits quantiques. On va maintenant décrire l'invention avec des détecteurs à transport horizontal.

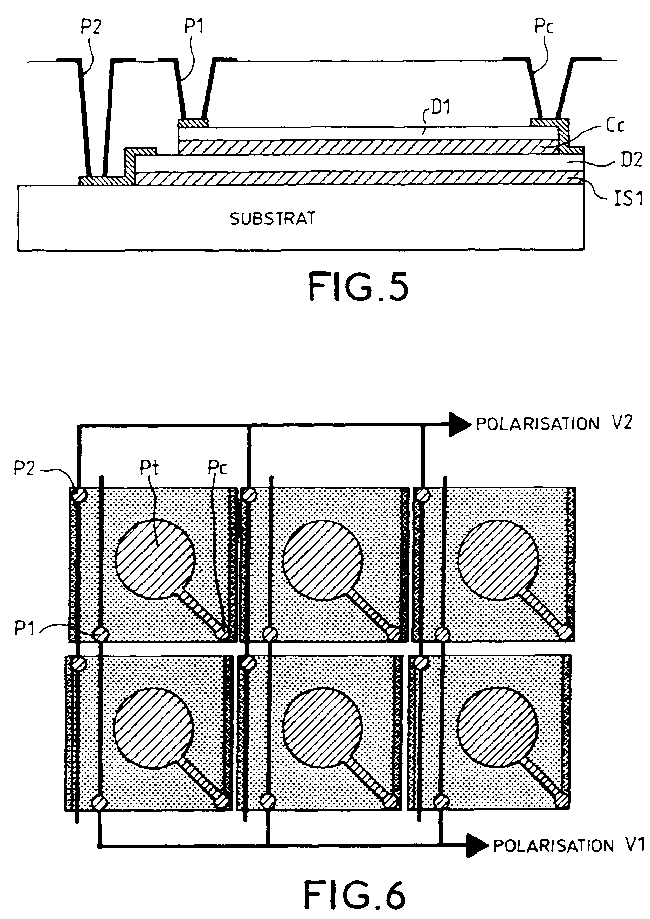

Le détecteur se compose de deux couches actives séparées par une couche isolante Cc (voir figure 5).

Des contacts ohmiques sont définis aux deux extrémités de chaque couche active D1, D2. A l'une des extrémités du détecteur, les contacts ohmiques sont mis en commun pour définir le contact de lecture Pc. Ce contact Pc (un contact par pixel) assurera la connexion avec l'étage d'entrée du circuit de lecture. Le contact inférieur P2 est relié à la couche active D2. Le contact supérieur P1 est relié à la couche active D1. On voit donc que lorsque les couches actives sont convenablement polarisées, le détecteur a un fonctionnement similaire à celui décrit précédemment avec la différence qu'on a une circulation de courant selon le plan des couches actives au lieu de perpendiculairement au plan des couches actives.

Sur la figure 5, on a prévu une couche d'isolant IS1 entre la couche active D2 et le substrat.

La figure 6 représente une organisation matricielle de détecteurs tels que ceux de la figure 5. Dans cette organisation tous les contacts P1 sont connectés ensembles par des fils de colonnes. Il en est de même pour les contacts P2 et Pc. Un plot central de test Pt par détecteur permet de faire un test de courant.

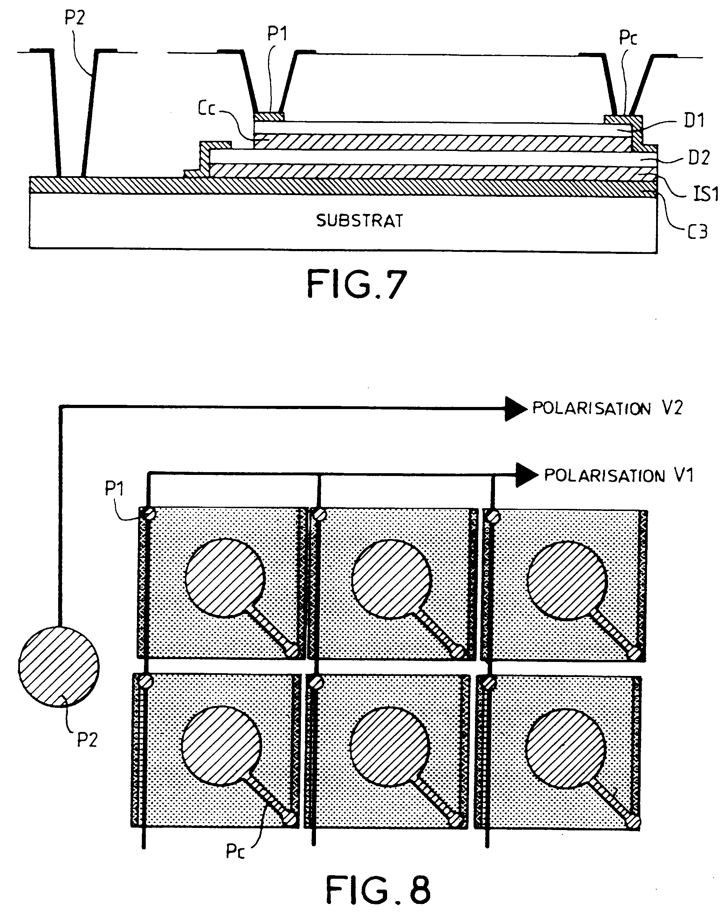

La figure 7 représente une variante de réalisation de la figure 5 comportant une couche conductrice C3 disposée sur le substrat et sur laquelle est réalisée la structure de la figure 5.

La figure 8 représente une organisation matricielle de détecteurs de la figure 7. La couche C3 permet, dans cette organisation matricielle, d'avoir un plot de connexion P2 unique et commun à tous les pixels détecteurs.

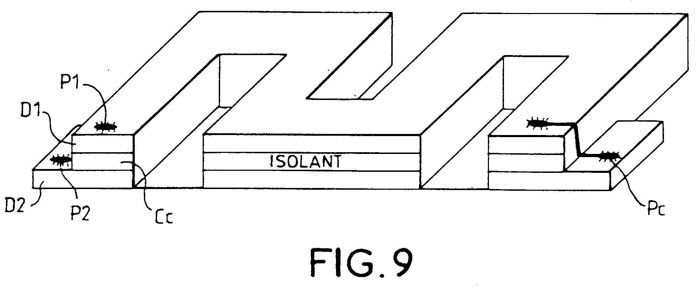

Un certain nombre de possibilités supplémentaires peuvent être utilisés :
- possibilité de prévoir des réseaux de diffraction gravés sur le dessus du détecteur pour minimiser l'épaisseur de la couche active et augmenter la détectivité du dispositif ; ils permettront également de dissymétriser la réponse des deux étages ;
- possibilité de réaliser une géométrie « serpentin » (voir figure 9) qui permet d'augmenter la résistance du pixel (augmentation de la longueur développée et diminution de la surface équivalente électrique pour une surface optique sensiblement identique) ; cette géométrie donne également un peu de souplesse en ce qui concerne les défauts métallurgiques car ceux-ci ne créent plus alors que des courts-circuits locaux.

## Revendications

1. Détecteur d'ondes électromagnétiques à photoconducteur comportant :
- au moins un premier et un deuxième éléments détecteurs actifs (D1, D2) empilés de forme plane séparés par une couche commune (Cc), les deux éléments détecteurs étant sensibles à des longueurs d'ondes différentes ;
- un premier moyen de connexion (Pc) connecté en commun aux deux éléments détecteurs, un deuxième moyen de connexion (P1) connecté au premier élément détecteur, et un troisième moyen de connexion connecté au deuxième élément détecteur (P2);
- des moyens pour appliquer successivement une tension de commande à chaque moyen de connexion ;
- des moyens connectés au premier moyen de connexion (Cc) pour détecter un courant de photoconduction à chaque application d'une tension de commande.

2. Détecteur selon la revendication 1, caractérisé en ce que la couche commune est une couche de contact électrique, le premier moyen de connexion (Cc) étant connecté à cette couche commune et en ce que l'ensemble des deux éléments détecteurs est enserré entre deux couches de contact de commande électrique (C1, C2), le deuxième et le troisième moyens de connexion (P1, P2) étant connectés chacun à une couche de contact de commande.

3. Détecteur selon la revendication 1, caractérisé en ce que la couche commune (Cc) est une couche isolante, en ce que le premier moyen de connexion est connecté à une première extrémité de chaque élément détecteur, et en ce que le deuxième et le troisième moyens de connexion sont connectés chacun à une deuxième extrémité d'un élément détecteur, la première extrémité et la deuxième extrémité de chaque élément détecteur étant des extrémités opposées dudit élément détecteur.

4. Détecteur selon la revendication 1, caractérisé en ce que les moyens pour appliquer une tension de commande permettant d'appliquer :
- un potentiel de référence (Vref) au premier moyen de connexion ;
- ledit potentiel de référence (Vref) au deuxième moyen de connexion ;
- un potentiel de commande (V1 ou V2) au troisième moyen de connexion.

5. Détecteur selon la revendication 4, caractérisé en ce que les moyens pour appliquer une tension de commande comportant des moyens de commutation (K1, K2) permettant, dans un premier temps d'appliquer un potentiel de commande (U1) à une première couche de contact de commande (C1) et le potentiel de référence (Vref) à la deuxième couche de contact de commande (C2), puis dans un deuxième temps, d'appliquer un potentiel de commande (U2) à la deuxième couche de contact de commande (C4) et le potentiel de référence (Vref) à la première couche de contact de commande (C1).

6. Détecteur caractérisé en ce qu'il comporte une matrice de détecteurs selon la revendication 2 réalisée sur un substrat, une première couche de contact de commande (C2) étant sur la face du substrat et étant commune à un ensemble de détecteurs, chaque détecteur comportant, sur cette première couche de contact de commande, un premier élément détecteur (D2) en matériau photoconducteur, une couche de contact de lecture (Cc), un deuxième élément détecteur (D1) en matériau photoconducteur, une deuxième couche de contact de commande (C2), les deuxièmes couches de contact de commande (C2) des différents détecteurs de la matrice étant interconnectées entre elles.

7. Détecteur selon la revendication 6, caractérisé en ce qu'il comporte une matrice de conducteurs de lignes et de conducteurs de colonnes superposée à la matrice de détecteurs, chaque détecteur étant localisé sensiblement à un point de croisement de la matrice de conducteurs de lignes et de colonnes et étant connectable au fil de colonne du point de croisement par un dispositif de commutation commandable par un potentiel appliqué au fil de ligne du point de croisement.

8. Détecteur selon la revendication 6, caractérisé en ce que :
- la première de couche de contact de commande (C2) est réalisée sous forme de bandes, une ligne de détecteurs étant réalisée sur chaque bande ;
en ce que :
- les deuxièmes couches de contact des détecteurs de chaque ligne de détecteurs sont également interconnectées ensemble ;
- et en ce que les couches de contact de lecture d'un détecteur de chaque ligne de détecteurs sont interconnectées ensemble pour former des colonnes de détecteurs.

9. Procédé de réalisation d'un détecteur selon la revendication 2, caractérisé en ce qu'il comporte les différentes étapes suivantes :
- réalisation sur un substrat:
• d'une première couche de contact (C2)
• d'au moins une première couche en matériau photoconducteur (D2)
• d'une deuxième couche de contact (Cc)
• d'au moins une deuxième couche en matériau photoconducteur (D1)
• d'une troisième couche de contact (C1)
- gravure de la troisième couche de contact (C1) et de la deuxième couche en matériau photoconducteur (D1) pour définir un premier élément détecteur ;
- gravure de la deuxième couche de contact (Cc) et de la première couche en matériau photoconducteur (D2) pour définir un deuxième élément détecteur ;
- encapsulation dans un isolant desdites couches ;
- gravure de trous dans la couche d'isolant pour accéder aux couches de contact et métallisation de ces trous.

10. Procédé de réalisation d'une matrice de détecteurs selon la revendication 9, caractérisé en ce qu'il prévoit la réalisation collective de plusieurs détecteurs sur un même substrat, la première couche de contact étant commune à tout ou partie des détecteurs, le procédé prévoyant en outre la gravure de la première couche en matériau photoconducteur (D2) avant encapsulation par l'isolant, ainsi que l'interconnexion de trous connectés à la troisième couche de contact dans les différents détecteurs.

11. Détecteur caractérisé en ce qu'il comporte une matrice de détecteurs selon la revendication 3, réalisé sur un substrat, une couche conductrice (C3) étant sur la face du substrat et étant communes à tous les détecteurs, cette couche étant recouverte par une couche isolante (IS1), chaque détecteur comportant, sur cette couche isolante, un premier élément détecteur (D2) en matériau photoconducteur, une couche commune isolante (Cc), un deuxième élément détecteur (D1) ) en matériau photoconducteur, les deuxièmes éléments de connexion étant connectés entre eux ainsi que les troisièmes éléments de connexion.
